# EUROPEAN PATENT APPLICATION

(11) **EP 4 290 771 A1**
(43) Date of publication of application: **13.12.2023**
(21) Application number: 22770373.3
(22) Date of filing: 10.03.2022
(51) Int. Cl.: H03H 3/007

(54) **MEMS RESONATOR AND PROCESSING METHOD FOR MEMS RESONATOR**

(30) Priority: 17.03.2021 CN 202110285274
(71) Applicant: Huawei Technologies Co., Ltd., Shenzhen, Guangdong 518129 (CN)
(72) Inventor: WU, Guoqiang, Wuhan, Hubei 430072 (CN); CHEN, Wen, Wuhan, Hubei 430072 (CN); HAN, Jinzhao, Wuhan, Hubei 430072 (CN); FENG, Zhihong, Shenzhen, Guangdong 518129 (CN)
(74) Representative: Thun, Clemens
(86) International application number: PCT/CN2022/080116
(87) International publication number: WO 2022/194018

(57) **Abstract**

Embodiments of this application disclose a MEMS resonator, which is used in fields of communications, clock devices, and the like. The MEMS resonator includes a substrate, a barrier layer, a conducting layer, a dielectric isolation layer, a harmonic oscillator, a first electrical isolation structure, and a first conducting structure. The substrate and the barrier layer are combined to form a cavity, and a junction between the substrate and the barrier layer includes the conducting layer. The dielectric isolation layer is included between the conducting layer and the barrier layer. The harmonic oscillator is connected to the conducting layer and is suspended in the cavity. The conducting layer is connected to a first conducting structure that is outside the barrier layer, and a first electrical isolation structure is included between the first conducting structure and the barrier layer. The barrier layer and the dielectric isolation layer are configured to isolate the first electrical isolation structure from the cavity. In this application, the first electrical isolation structure is isolated from the cavity, to prevent hydrofluoric acid vapor from corroding the first electrical isolation structure during processing, and improve a yield of the MEMS resonator

## Description

This application claims priority to Chinese Patent Application No. CN202110285274.X, filed with the China National Intellectual Property Administration on March 17, 2021 and entitled "MEMS RESONATOR AND MEMS RESONATOR PROCESSING METHOD", which is incorporated herein by reference in its entirety.

### TECHNICAL FIELD

This application relates to the field of clock devices, and in particular, to a MEMS resonator and a MEMS resonator processing method.

### BACKGROUND

Compared with conventional electronic devices, micro electro mechanical system (Micro Electro Mechanical System, MEMS) devices have advantages of a small size, a light weight, low power consumption, and the like.

Accordingly, compared with conventional electronic devices, MEMS devices have stricter requirements on packaging technologies. For example, for a MEMS resonator, vacuum packaging is performed on a harmonic oscillator in the MEMS resonator to reduce an air damping loss of the harmonic oscillator, thereby increasing a quality factor (quality factor, Q) value of the harmonic oscillator. A sacrificial layer originally exists in a vacuum cavity, serving as a support during processing. During processing of a MEMS resonator packaged by using a thin film, breather holes are etched on an upper cavity wall of the vacuum cavity. Hydrofluoric acid vapor is injected through the breather holes to corrode the sacrificial layer to form the vacuum cavity. A size of the vacuum cavity is directly proportional to duration of corrosion.

Therefore, if corrosion time is excessively long, the size of the vacuum cavity continuously increases, and the hydrofluoric acid vapor may corrode an electrical isolation structure used for electrical isolation. This causes a short circuit, thereby reducing a yield of the MEMS resonator.

### SUMMARY

This application provides a MEMS resonator and a MEMS resonator processing method. A first electrical isolation structure and a cavity are isolated by using a barrier layer and a dielectric isolation layer, to prevent hydrofluoric acid vapor from corroding the first electrical isolation structure, and improve a yield of the MEMS resonator.

A first aspect of this application provides a MEMS resonator. The MEMS resonator includes a substrate, a barrier layer, a conducting layer, a dielectric isolation layer, a harmonic oscillator, a first electrical isolation structure, and a first conducting structure. The substrate and the barrier layer are combined to form a cavity, a junction between the substrate and the barrier layer includes the conducting layer, the dielectric isolation layer is included between the conducting layer and the barrier layer, and the dielectric isolation layer is configured to isolate electrical connection between the conducting layer and the barrier layer. The harmonic oscillator is connected to the conducting layer and is suspended in the cavity. The conducting layer is connected to the first conducting structure that is outside the barrier layer. The first conducting structure may provide excitation for the harmonic oscillator, so that the harmonic oscillator in the harmonic oscillator vibrates in the cavity. The first electrical isolation structure is included between the first conducting structure and the barrier layer. The first electrical isolation structure is configured to isolate electrical connection between the first conducting structure and the barrier layer. The barrier layer and the dielectric isolation layer are configured to isolate the first electrical isolation structure from the cavity.

In this application, the first electrical isolation structure and the cavity are isolated by using the barrier layer and the dielectric isolation layer, to prevent hydrofluoric acid vapor from corroding the first electrical isolation structure, thereby reducing a probability of a short circuit and improving a yield of the MEMS resonator. In addition, a material of the barrier layer may be a conductive material, such as polycrystalline silicon or amorphous silicon. When electrical connection exists between the barrier layer and the conducting layer, the MEMS resonator generates a leakage, which affects normal use of the MEMS resonator. In this application, electrical connection between the barrier layer and the conducting layer can be isolated by disposing the dielectric isolation layer, to improve reliability of the MEMS resonator.

In an optional implementation of the first aspect, the barrier layer includes a first barrier layer and a second barrier layer. Breather holes are disposed on the first barrier layer. During processing of the MEMS resonator, hydrofluoric acid vapor may be injected through the breather holes to corrode a sacrificial layer in the original cavity. The second barrier layer is configured to seal the breather holes to seal the harmonic oscillator in the cavity. Therefore, this can effectively reduce an air damping loss of the harmonic oscillator, thereby increasing a Q value of the harmonic oscillator.

In an optional implementation of the first aspect, a material of the second barrier layer is polycrystalline silicon or amorphous silicon. When polycrystalline silicon or amorphous silicon is formed at a high temperature, residual gas in the cavity can be removed, thereby increasing a Q value of the MEMS resonator.

In an optional implementation of the first aspect, a material of the first barrier layer is different from a material of the first electrical isolation structure. The first electrical isolation structure, for example, silicon oxide, is corroded by hydrofluoric acid vapor. The first barrier layer is exposed to the hydrofluoric acid vapor directly, to prevent the hydrofluoric acid vapor from corroding the first electrical isolation structure. Therefore, the material of the first electrical isolation and the material of the first barrier layer are defined to be different.

In an optional implementation of the first aspect, the material of the second barrier layer is the same as the material of the first barrier layer. The second barrier layer is configured to seal the breather holes on the first barrier layer. When the material of the second barrier layer is the same as the material of the first barrier layer, sealing performance can be improved.

In an optional implementation of the first aspect, the harmonic oscillator includes an upper electrode layer, a piezoelectric layer, and a lower electrode layer, and the piezoelectric layer is located between the upper electrode layer and the lower electrode layer. During a process of forming the second barrier layer at a high temperature, materials of the upper electrode layer and the piezoelectric layer may be oxidized at the high temperature. The dielectric isolation layer covers the upper electrode layer and the piezoelectric layer, to protect the upper electrode layer and the piezoelectric layer. Therefore, this application can improve flexibility of drive detection and frequency modulation of the MEMS resonator.

In an optional implementation of the first aspect, a material of the dielectric isolation layer is aluminum oxide Al₂O₃.

In an optional implementation of the first aspect, a thickness of the dielectric isolation layer is 0.01 µm to 2 µm.

In an optional implementation of the first aspect, the MEMS resonator further includes a functional electrode, and the functional electrode and the harmonic oscillator form a capacitor. When a direct current bias voltage is applied to the functional electrode, the harmonic oscillator generates an offset in a fixed direction. When the harmonic oscillator generates an offset, a resonance frequency of the harmonic oscillator changes. In this application, the functional electrode is disposed, to implement frequency adjustment of the harmonic oscillator.

In an optional implementation of the first aspect, the functional electrode includes a first functional electrode and a second functional electrode. The first functional electrode and the harmonic oscillator form a first capacitor, and the second functional electrode and the harmonic oscillator form a second capacitor. The first capacitor and the second capacitor are distributed symmetric about the harmonic oscillator. The two symmetric functional electrodes are disposed to increase an offset amount of the harmonic oscillator, thereby expanding a range of frequency adjustment of the harmonic oscillator

In an optional implementation of the first aspect, the functional electrode is connected to a second conducting structure that is outside the barrier layer, and a second electrical isolation structure is included between the second conducting structure and the barrier layer. The barrier layer and the dielectric isolation layer are configured to isolate the second electrical isolation structure from the cavity. The second electrical isolation structure and the cavity are isolated by using the barrier layer and the dielectric isolation layer, to prevent hydrofluoric acid vapor from corroding the second electrical isolation structure, thereby reducing a probability of a short circuit and improving a yield of the MEMS resonator.

In an optional implementation of the first aspect, when an alternating current voltage is applied to the functional electrode, the harmonic oscillator vibrates based on the alternating current voltage. When an alternating current voltage is applied to the functional electrode, the alternating current voltage is used as vibration excitation of the harmonic oscillator, which is briefly referred to as electrostatic excitation. In this case, a voltage applied to the upper electrode layer may be used to perform detection on a vibration frequency of the harmonic oscillator, which is briefly referred to as piezoelectric detection. Through piezoelectric detection, it can be determined whether the vibration frequency of the harmonic oscillator meets an expected frequency. Therefore, in this application, reliability of the MEMS resonator can be improved through piezoelectric detection.

In an optional implementation of the first aspect, the MEMS resonator further includes a support beam. The harmonic oscillator is connected to the conducting layer through the support beam and is suspended in the cavity.

In an optional implementation of the first aspect, a material of the functional electrode is the same as a material of the lower electrode layer of the harmonic oscillator. When the material of the functional electrode is the same as the material of the lower electrode layer of the harmonic oscillator, processing steps of the MEMS resonator can be reduced, thereby reducing processing costs.

In an optional implementation of the first aspect, the MEMS resonator further includes a protective layer above the barrier layer.

In an optional implementation of the first aspect, an electrical through-hole is disposed on the protective layer, and an electrode pad is deposited on the electrical through-hole. The electrode pad is connected to the first conducting structure.

In an optional implementation of the first aspect, a silicon oxide layer is included on a surface of the substrate. The silicon oxide layer is added to isolate electrical connection between the harmonic oscillator and the substrate. This reduces a probability of electric leakage, and improves reliability of the MEMS resonator.

In an optional implementation of the first aspect, a processing temperature of the second barrier layer is greater than 500 degrees Celsius. The processing temperature may be a temperature in an epitaxial growth process, or may be a temperature in a crystallization process. For example, when the second barrier layer is polycrystalline silicon, the second barrier layer may be obtained by epitaxially growing polycrystalline silicon in a high-temperature environment. Alternatively, the second barrier layer of polycrystalline silicon may be obtained by epitaxially growing amorphous silicon and then annealing the amorphous silicon at a high temperature to crystallize.

A second aspect of this application provides a MEMS resonator processing method. The method includes: providing a silicon-on-insulator (Silicon on insulator, SOI) wafer including a substrate and a conducting layer; etching the conducting layer to form a harmonic oscillator and a support beam, where the harmonic oscillator is connected to the conducting layer through the support beam; depositing a dielectric isolation layer and a sacrificial layer on the conducting layer; etching the sacrificial layer, and epitaxially growing or depositing a first barrier layer on the sacrificial layer, so that the harmonic oscillator is located in an area formed by the first barrier layer and the substrate; etching breather holes on the first barrier layer; injecting hydrofluoric acid vapor through the breather holes to corrode the sacrificial layer in the area, so that the harmonic oscillator is suspended, through the support beam, in a cavity formed by the area; and epitaxially growing a second barrier layer on the first barrier layer to seal the harmonic oscillator in the cavity. The conducting layer is connected to a first conducting structure that is outside the barrier layer, a first electrical isolation structure is included between the first conducting structure and the barrier layer, and the barrier layer and the dielectric isolation layer are configured to isolate the first electrical isolation structure from the cavity.

In an optional implementation of the second aspect, a material of the second barrier layer is polycrystalline silicon or amorphous silicon.

In an optional implementation of the second aspect, a material of the first barrier layer is different from a material of the first electrical isolation structure.

In an optional implementation of the second aspect, the material of the second barrier layer is the same as the material of the first barrier layer

In an optional implementation of the second aspect, the method further includes: generating a piezoelectric layer on the conducting layer, and depositing an upper electrode layer on the piezoelectric layer. The dielectric isolation layer covers the upper electrode layer and the piezoelectric layer of the harmonic oscillator.

In an optional implementation of the second aspect, a material of the dielectric isolation layer is aluminum oxide Al₂O₃.

In an optional implementation of the second aspect, a thickness of the dielectric isolation layer is 0.01 µm to 2 µm.

In an optional implementation of the second aspect, the MEMS resonator further includes a functional electrode, and the functional electrode and the harmonic oscillator form a capacitor. When a direct current bias voltage is applied to the functional electrode, the harmonic oscillator generates an offset in a fixed direction.

In an optional implementation of the second aspect, the functional electrode includes a first functional electrode and a second functional electrode. The first functional electrode and the harmonic oscillator form a first capacitor. The second functional electrode and the harmonic oscillator form a second capacitor. The first capacitor and the second capacitor are distributed symmetric about the harmonic oscillator.

In an optional implementation of the second aspect, the conducting layer is connected to a first conducting structure that is outside the barrier layer, a first electrical isolation structure is included between the first conducting structure and the barrier layer, and the barrier layer and the dielectric isolation layer are configured to isolate the first electrical isolation structure from the cavity.

In an optional implementation of the second aspect, a material of the functional electrode is the same as a material of the lower electrode layer of the harmonic oscillator

In an optional implementation of the second aspect, the method further includes: depositing a protective layer on the barrier layer.

In an optional implementation of the second aspect, the method further includes: etching an electrical through-hole on the protective layer, and depositing an electrode pad on the electrical through-hole.

In an optional implementation of the second aspect, a processing temperature of the second barrier layer is greater than 500 degrees Celsius.

A third aspect of this application provides a clock device. The clock device includes a MEMS resonator and a maintaining circuit. The maintaining circuit provides closed-loop oscillation excitation for the MEMS resonator. The MEMS resonator generates a clock signal through oscillation excitation. The MEMS resonator is the MEMS resonator according to the foregoing first aspect.

A fourth aspect of this application provides a terminal. The terminal includes a clock device and a processor. The clock device is configured to provide a clock signal for the processor. The processor performs operation processing based on the clock signal. The clock device is the clock device according to the foregoing third aspect.

A fifth aspect of this application provides a computer storage medium. The computer storage medium stores instructions. When the instructions are executed on a computer, the computer is enabled to perform the method according to the second aspect or any one of the implementations of the second aspect.

A sixth aspect of this application provides a computer program product. The computer program product. When the computer product is executed on a computer, the computer is enabled to perform the method according to the second aspect or any one of the implementations of the second aspect.

### BRIEF DESCRIPTION OF DRAWINGS

FIG. 1 is a schematic flowchart of a MEMS resonator processing method according to this application;
FIG. 2a to FIG. 21 are schematic diagrams of a structure of a MEMS resonator in different processing stages according to this application;
FIG. 3 is a schematic top view of a structure of a MEMS resonator according to this application;
FIG. 4 is a schematic diagram of a three-dimensional structure of a MEMS resonator according to this application;
FIG. 5a to FIG. 51 are schematic diagrams of another structure of a MEMS resonator in different processing stages according to this application;
FIG. 6 is a schematic diagram of electrical connections of a MEMS resonator according to this application;
FIG. 7 is a schematic diagram of a structure of a MEMS resonator according to this application;
FIG. 8 is a schematic diagram of a structure of a clock device according to this application; and
FIG. 9 is a schematic diagram of a structure of a terminal according to this application.

### DESCRIPTION OF EMBODIMENTS

This application provides a MEMS resonator and a MEMS resonator processing method, applied to the field of clock devices. A first electrical isolation structure and a cavity are isolated by using a barrier layer and a dielectric isolation layer, to prevent hydrofluoric acid vapor from corroding the first electrical isolation structure, and improve a yield of the MEMS resonator.

It should be understood that, in the description of embodiments of this application, terms such as "first" and "second" are merely used for distinguishing and description purposes, but shall not be understood as indicating or implying relative importance, or shall not be understood as indicating or implying a sequence.

It should be understood that, because a person of ordinary skill in the art is familiar with steps and/or components in the processing method, each processing step and/or component of the MEMS resonator may merely be briefly described in this application. In addition, different processing steps and/or components for achieving a same purpose may be interchanged. Therefore, specific examples of processing steps and/or components are described in this application to simplify the technical solutions disclosed in this application. Certainly, these examples are not intended to impose a limitation. In addition, for brevity and clarity, reference numbers and/or letters are repeated in embodiments of this application. Repetition does not indicate that there is a strict restrictive relationship between various embodiments and/or configurations.

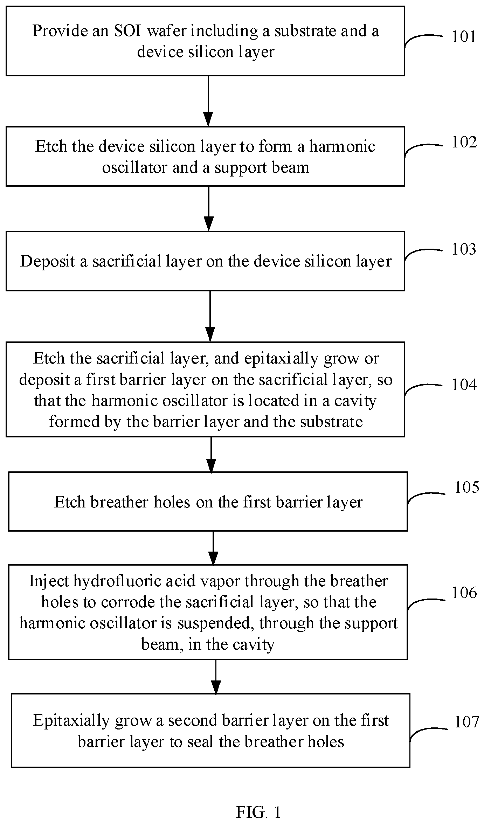

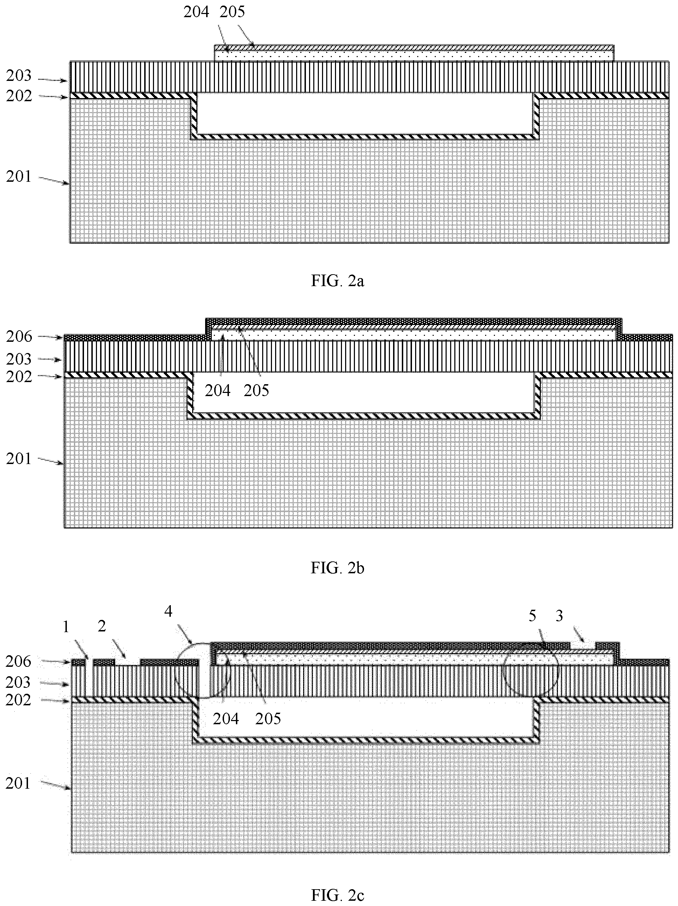

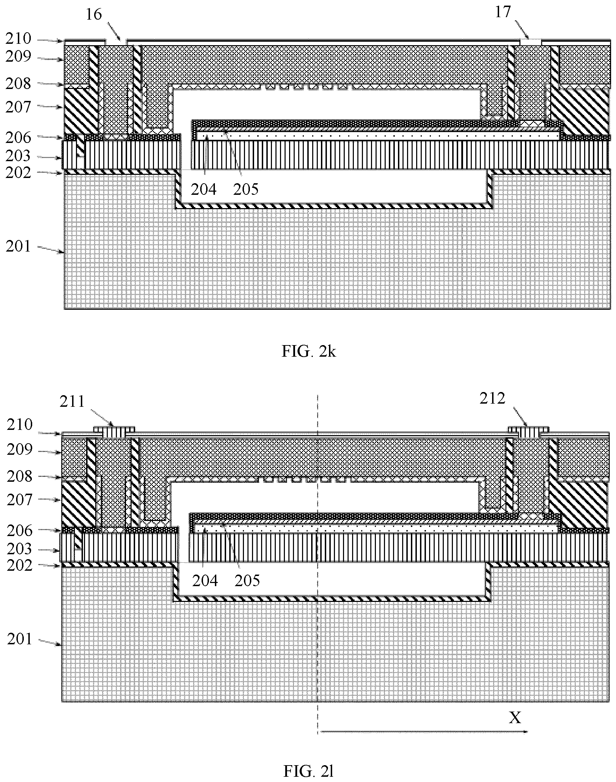

FIG. 1 is a schematic flowchart of a MEMS resonator processing method according to this application. To facilitate description of the MEMS resonator processing method, corresponding descriptions are provided subsequently with reference to schematic diagrams of a structure of a MEMS resonator in different processing stages. Specifically, FIG. 2a to FIG. 21 are schematic diagrams of a structure of a MEMS resonator in different processing stages according to this application. As shown in FIG. 1, the processing method includes the following steps.

Step 101: Provide an SOI wafer including a substrate and a device silicon layer.

The SOI wafer is also referred to as a carrier wafer, and the carrier wafer is a silicon wafer. As shown in FIG. 2a, an SOI wafer includes a substrate 201, a silicon oxide layer 202, and a device silicon layer 203. The silicon oxide layer 202 is located between the substrate 201 and the device silicon layer 203, and is configured to implement electrical isolation between the substrate 201 and the device silicon layer 203. The silicon oxide layer 202 may be silicon oxide obtained through thermal oxidation. Compared with silicon oxide obtained through chemical vapor deposition (Chemical Vapor Deposition, CVD), the silicon oxide obtained through thermal oxidation has higher density and is not easy to corrode. The substrate 201 is also referred to as a base. Materials of the substrate 201 and the device silicon layer 203 may be the same or may be different. For example, materials of the substrate 201 and the device silicon layer 203 may be Si-based materials, ceramic materials, or polymer materials. In addition, the substrate 201 and the device silicon layer 203 may further include other-element (such as germanium) semiconductors or other-compound (such as silicon carbide, gallium arsenide, indium arsenide, and indium phosphate) semiconductors. Because materials of the substrate 201 and the device silicon layer 203 do not affect implementation of the technical solutions, the materials of the substrate 201 and the device silicon layer 203 are not limited in this application. A cavity is included between the device silicon layer 203 and the silicon oxide layer 202. A shape of the cavity may be a cuboid, cylinder, prism, or prism structure. In another embodiment, a shape of the cavity is adapted to a shape of a harmonic oscillator. For example, if the shape of the cavity is a cylinder, the shape of the harmonic oscillator is a cylinder with a smaller radius. For example, if the shape of the cavity is a rectangle, the shape of the harmonic oscillator is a similar rectangle. The harmonic oscillator can be suspended in the cavity through a subsequent etching process.

As shown in FIG. 2a, a piezoelectric layer 204 and an upper electrode layer 205 are included on the device silicon layer 203. Specifically, the piezoelectric layer 204 with a thickness of 0.3 µm to 1.5 µm is sputtered on the device silicon layer 203 through a magnetron sputtering method. A material of the piezoelectric layer 204 may be aluminum nitride AlN, doped aluminum nitride, lithium niobate, zinc oxide ZnO, plumbum zirconate titanate PZT, or the like. Then, the upper electrode layer 205 is deposited on the piezoelectric layer 204 by using a low pressure chemical vapor deposition (Low Pressure Chemical Vapor Deposition, LPCVD) or physical vapor deposition (Physical Vapor Deposition, PVD) method. A material of the upper electrode layer 205 may be polycrystalline silicon or metal, and the metal may be molybdenum, platinum, titanium, aluminum, or the like.

In another embodiment, a dielectric isolation layer 206 with a thickness of 0.01 µm to 2 µm is deposited on the upper electrode layer 205 through atomic layer deposition. As shown in FIG. 2b, the dielectric isolation layer 206 covers the upper electrode layer 205 and the piezoelectric layer 204. A material of the dielectric isolation layer 206 is aluminum oxide Al₂O₃.

Step 102: Etch the device silicon layer to form a harmonic oscillator and a support beam.

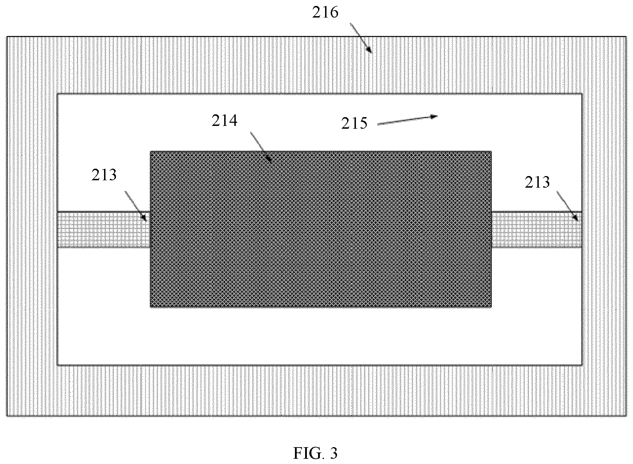

As shown in FIG. 2c, a harmonic oscillator and a support beam are formed by etching the device silicon layer 203. The support beam may be understood as areas shown in circle 4 and circle 5 in FIG. 2c. Specifically, FIG. 3 is a schematic top view of a structure of a MEMS resonator according to this application. As shown in FIG. 3, the MEMS resonator includes a harmonic oscillator 214 and a fixed portion 216. The fixed portion 216 may be the substrate 201 in FIG. 2c, or the device silicon layer 203, or a combination of the substrate 201 and the device silicon layer 203. The harmonic oscillator 214 is connected to the fixed portion 216 through a support beam 213 and is suspended in a cavity 215. In FIG. 3, the MEMS resonator includes two support beams 213. In FIG. 2c, positions marked by circle 4 and circle 5 correspond to the two support beams 213. To show that the harmonic oscillator is suspended in the cavity in FIG. 2c, the support beam is not shown in circle 4. In addition, to show that the harmonic oscillator is connected to the substrate through the support beam in FIG. 2c, the support beam is shown in circle 5. It should be understood that the support beam shown in FIG. 3 is merely an example. In actual application, there may be one or more support beams. The support beam may be a straight beam, a T-shaped beam, a cross beam, or the like.

In addition to etching of the device silicon layer 203 to form the harmonic oscillator, the dielectric isolation layer 206 may be etched to prepare for subsequent electrical connection. As shown in FIG. 2c, an opening 1, an opening 2, and an opening 3 are formed by etching the dielectric isolation layer 206. The opening 3 is connected to the upper electrode layer 205, and is used for electrical connection to the upper electrode. The device silicon layer 203 between the support beams is used as a lower electrode layer of the harmonic oscillator. The opening 2 is connected to the lower electrode layer through the device silicon layer 203, and is used for electrical connection to the lower electrode. The opening 1 is configured to isolate connection between the lower electrode layer of the harmonic oscillator and an edge part of the device silicon layer 203, to implement electrical isolation.

Step 103: Deposit a sacrificial layer on the device silicon layer.

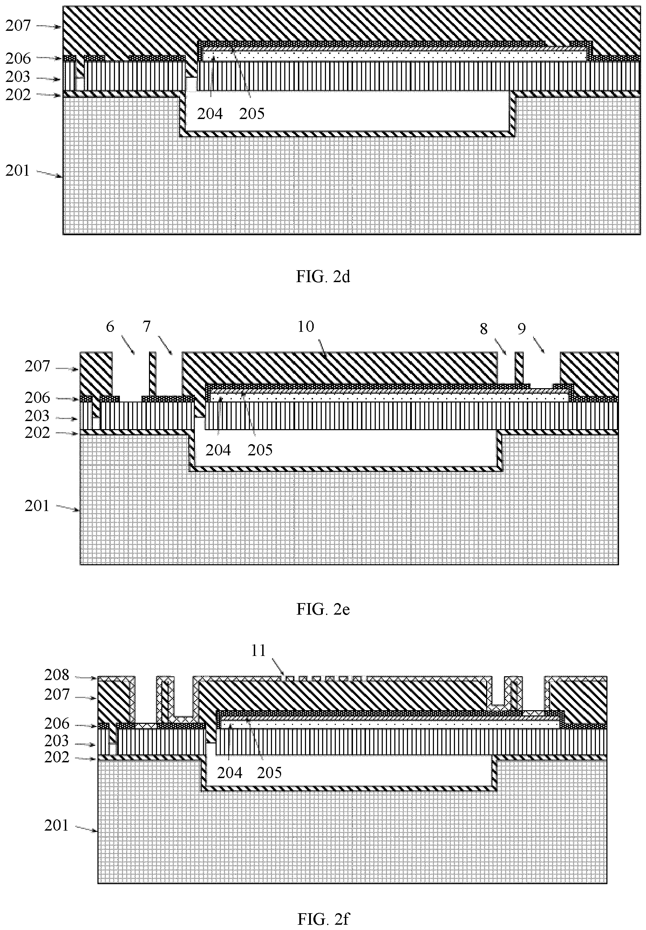

As shown in FIG. 2d, after the device silicon layer 203 is etched to form the harmonic oscillator, a sacrificial layer 207 with a thickness of 1 µm to 10 µm is deposited on the device silicon layer 203 by using a PVD or CVD method. It should be understood that, because the dielectric isolation layer 206 is deposited on the device silicon layer 203, depositing the sacrificial layer 207 on the device silicon layer 203 may also be understood as depositing the sacrificial layer 207 on the dielectric isolation layer 206.

Step 104: Etch the sacrificial layer, and epitaxially grow or deposit a first barrier layer on the sacrificial layer, so that the harmonic oscillator is located in a cavity formed by the first barrier layer and the substrate.

As shown in FIG. 2e, an opening 6, an opening 7, an opening 8, and an opening 9 are formed by etching the sacrificial layer 207. The opening 6 is connected to the opening 2 on the dielectric isolation layer 206, and is used for subsequent generation of a first conducting structure, so as to prepare for electrical connection to the lower electrode. The opening 9 is connected to the opening 3 on the dielectric isolation layer 206. The opening 9 is used for subsequent generation of a first conducting structure, so as to prepare for electrical connection to the upper electrode. The opening 7 and the opening 8 are connected to the dielectric isolation layer 206. The opening 7 and the opening 8 are used for subsequent generation of a barrier layer. A distance between the opening 7 and the opening 8 is a width, in an X-axis direction (for details, refer to FIG. 3), of a cavity in which a subsequent harmonic oscillator is located. An area in which the sacrificial layer 207 between the opening 7 and the opening 8 is located is referred to as an area 10. The sacrificial layer 207 between the opening 6 and the opening 7, and between the opening 8 and the opening 9 is referred to as a first electrical isolation structure.

As shown in FIG. 2f, a first barrier layer 208 is epitaxially grown on an etched sacrificial layer 207, or a first barrier layer 208 is deposited on an etched sacrificial layer 207 by using an LPCVD method. A material of the first barrier layer 208 is polycrystalline silicon. Because the opening 7 and the opening 8 on the sacrificial layer 207 are directly connected to the dielectric isolation layer 206, the first barrier layer 208 obtained through epitaxial growth or deposition is also connected to the dielectric isolation layer 206. The first barrier layer 208 is used as a transverse barrier layer of the sacrificial layer 207 in the area 10. In this case, the harmonic oscillator is located in an area formed by the first barrier layer 208 and the substrate 201.

Step 105: Etch breather holes on the first barrier layer.

As shown in FIG. 2f, breather holes 11 are etched on the first barrier layer 208. The breather holes 11 are connected to the sacrificial layer 207 in the area 10.

Step 106: Inject hydrofluoric acid vapor through the breather holes to corrode the sacrificial layer, so that the harmonic oscillator is suspended, through the support beam, in the cavity.

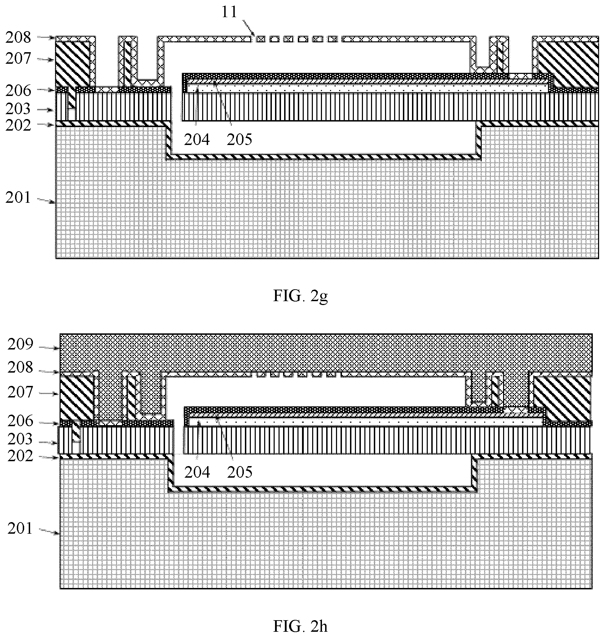

As shown in FIG. 2g, because the breather holes 11 are connected to the sacrificial layer 207 in the area 10, after the hydrofluoric acid vapor is injected through the breather holes 11, the hydrofluoric acid vapor corrodes the sacrificial layer 207 in the area 10. In addition, because the first barrier layer 208 is used as the transverse barrier layer of the sacrificial layer 207 in the area 10, the sacrificial layer 207 in the area 10 is isolated from the first electrical isolation structure (the sacrificial layer 207 between the opening 6 and the opening 7, and between the opening 8 and the opening 9). Therefore, the hydrofluoric acid vapor does not corrode the first electrical isolation structure. Through corrosion of the sacrificial layer 207 in the area 10, the harmonic oscillator may be released, so that the harmonic oscillator is connected to the substrate 201 through the support beam and is suspended in the cavity. It should be understood that, the harmonic oscillator may be directly connected to the substrate 201 through the support beam, or may be indirectly connected to the substrate 201.

Step 107: Epitaxially grow a second barrier layer on the first barrier layer to seal the breather holes.

As shown in FIG. 2h, a second barrier layer 209 is epitaxially grown in a high-temperature vacuum environment to seal the breather holes 11. A material of the second barrier layer 209 is polycrystalline silicon or amorphous silicon. When the material of the second barrier layer 209 is polycrystalline silicon, the material of the second barrier layer 209 is the same as a material of the first barrier layer 208. A thickness of the second barrier layer 209 is greater than a thickness of the first barrier layer 208. It can be learned from the foregoing description of step 106 that, to inject hydrofluoric acid vapor, the breather holes 11 need to be etched on the first barrier layer 208. Therefore, a smaller thickness of the first barrier layer 208 indicates lower difficulty of etching the breather holes 11. By defining a thickness of the second barrier layer to be greater than a thickness of the first barrier layer, difficulty of etching the breather holes 11 can be reduced, and processing efficiency can be improved. After the second barrier layer 209 is epitaxially grown, a polishing process may be performed on the second barrier layer 209 to prepare for subsequent deposition of a protective layer

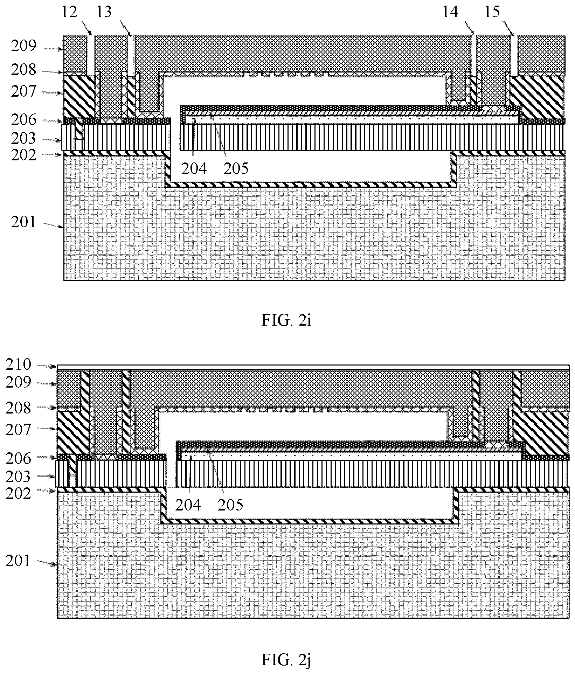

After the second barrier layer 209 is epitaxially grown, an electrical isolation groove is etched on the second barrier layer 209. As shown in FIG. 2i, the electrical isolation groove includes an opening 12, an opening 13, an opening 14, and an opening 15. The opening 13 and the opening 14 are connected to the first electrical isolation structure. The second barrier layer 209 or the first barrier layer 208 between the opening 12 and the opening 13, and between the opening 14 and the opening 15 is referred to as a first conducting structure. The opening 12 and the opening 15 are configured to isolate connection between the first conducting structure and an edge part of the second barrier layer 209, to implement electrical isolation.

After the electrical isolation groove is etched, a protective layer 210 is deposited on the second barrier layer 209 by using an LPCVD method. As shown in FIG. 2j, the protective layer 210 is located above the second barrier layer 209. In addition, the electrical isolation groove is filled with the protective layer 210, to implement connection between the first conducting structure and the second barrier layer 209 or the first barrier layer 208. A material of the protective layer 210 may be silicon oxide.

After the protective layer 210 is deposited, an electrical through-hole is etched on the protective layer 210. As shown in FIG. 2k, the electrical through-hole includes an opening 16 and an opening 17. The opening 16 and the opening 17 are conducted to the first conducting structure. Then, an electrical pad is formed by depositing metal on the electrical through-hole, for example, depositing aluminum. As shown in FIG. 21, the electrical pad includes an upper electrode pad 212 formed on the opening 16 and a lower electrode pad 211 formed on the opening 17. In this case, the upper electrode pad 212 is connected to the upper electrode layer 205 of the harmonic oscillator through the first conducting structure. The lower electrode pad 211 is connected to the device silicon layer 203 through the first conducting structure, and the device silicon layer 203 is connected to the lower electrode layer of the harmonic oscillator through the support beam. An excitation voltage may be applied to the harmonic oscillator through the lower electrode pad 211 and the upper electrode pad 212, so that the harmonic oscillator vibrates in the cavity.

It should be understood that the foregoing MEMS resonator processing method merely uses one or more examples. In actual application, because a person of ordinary skill in the art is familiar with the steps and/or components in the processing method, a person of ordinary skill in the art may adaptively change the steps in the foregoing processing method or the structure of the MEMS resonator.

For example, after the sacrificial layer 207 is deposited on the device silicon layer 203, chemical mechanical polishing (Chemical Mechanical Polishing, CMP) is performed on the sacrificial layer 207. A thickness of the sacrificial layer 207 can be controlled through CMP processing, to prepare for subsequent epitaxial growth of the first barrier layer 208.

For example, breather holes are etched on the substrate 201, and hydrofluoric acid vapor is injected through the breather holes on the substrate 201. In this case, there is no need to etch breather holes on the first barrier layer 208. In addition, a thickness of the first barrier layer 208 is epitaxially grown to a thickness of the first barrier layer 208 plus a thickness of the second barrier layer 209. In this case, there is no need for a second barrier layer. After the sacrificial layer 207 in the area 10 is corroded, the breather holes on the substrate 201 are sealed to seal the harmonic oscillator in the cavity.

For example, metal may be deposited on the device silicon layer 203 as a lower electrode layer of the harmonic oscillator, and the metal includes molybdenum, platinum, titanium, aluminum, or the like. In this case, during a subsequent electrical connection process, the lower electrode pad 212 is connected to the device silicon layer 203 through the first conducting structure, and the device silicon layer 203 is connected to the metal lower electrode layer through the support beam.

For example, as shown in FIG. 2i, the opening 12 and the opening 15 are configured to accommodate the first electrical isolation structure, and the first electrical isolation structure is configured to isolate connection between the first conducting structure and an edge part of the second barrier layer 209. Through isolation of the edge part of the second barrier layer 209, the first electrical isolation structure may isolate the first conducting structure (which is referred to as a conducting structure 1) connected to the lower electrode pad 211 from the first conducting structure (which is referred to as a conducting structure 2) connected to the upper electrode pad 212. The conducting structure 1 is configured to connect to the lower electrode layer of the harmonic oscillator, and the conducting structure 2 is configured to connect to the upper electrode layer of the harmonic oscillator Therefore, there is no electrical connection between the conducting structure 1 and the conducting structure 2. In a three-dimensional manner, a first electrical isolation structure is wound around a side edge of the conducting structure 1, and another first electrical isolation structure is wound around a side edge of the conducting structure 2, to divide the second barrier layer 209 into three parts. One part is the conducting structure 1, another part is the conducting structure 2, and the other part is an area other than the conducting structure 1 and the conducting structure 2. If the first electrical isolation structure is not wound around a side edge of the conducting structure 2, the second barrier layer 209 is divided into two parts. One part is the conducting structure 1, and the other part is an area other than the conducting structure 1. In this case, the lower electrode pad 211 may be located in any area of the other part. Further, an isolation layer is formed around a side edge of the MEMS resonator, to isolate a voltage generated by the lower electrode pad 211.

For example, the dielectric isolation layer 206 has two functions, one of which is to isolate oxygen to prevent the piezoelectric layer 204 and the upper electrode layer 205 from being oxidized. If the piezoelectric layer 204 and the upper electrode layer 205 are made of an antioxidant material, or oxidation of the piezoelectric layer 204 and the upper electrode layer 205 is acceptable, in step 101, the dielectric isolation layer 206 may not be deposited on the upper electrode layer 205. The other function of the dielectric isolation layer 206 is electrical isolation. Specifically, as shown in FIG. 21, near the lower electrode pad 211, the dielectric isolation layer 206 is configured to isolate connection between the second barrier layer 209 and the device silicon layer 203. Near the upper electrode pad 212, the dielectric isolation layer 206 is configured to isolate connection between the second barrier layer 209 and the upper electrode layer 205. If the dielectric isolation layer 206 is not deposited on the upper electrode layer 205, another manner needs to be used to implement an electrical isolation function. For example, as shown in FIG. 2e, an opening 7 and an opening 8 are formed by etching the sacrificial layer 207. Because the dielectric isolation layer 206 is not included, the opening 7 is directly connected to the device silicon layer 203, and the opening 8 is directly connected to the upper electrode layer 205. After the opening 7 and the opening 8 are formed and before the first barrier layer 208 is epitaxially grown, a non-conductive isolation layer is generated at the bottom of the opening 7 and the opening 8. The isolation layer is configured to implement an electrical isolation function. Specifically, the isolation layer is configured to isolate electrical connection between the first barrier layer 208 and the device silicon layer 203, and between the first barrier layer 208 and the upper electrode layer 205. In addition, it should be further noted that the isolation layer should not be corroded by hydrofluoric acid vapor. In this application, the dielectric isolation layer 206 is not only used as an isolation layer, but also used as a transverse barrier layer.

It should be understood that, in a case in which the dielectric isolation layer 206 is not included, if the opening 7 is not directly connected to the device silicon layer 203, that is, a sacrificial layer 207 (which is referred to as an isolation structure) is further included between the opening 7 and the conducting layer 203, an electrical isolation function of the dielectric isolation layer 206 can still be implemented. In this case, the sacrificial layer 207 in the area 10, the isolation structure, and the first electrical isolation structure (the sacrificial layer 207 between the opening 6 and the opening 7) are connected to each other. When the sacrificial layer 207 in the area 10 is corroded by hydrofluoric acid vapor injected through the breather holes 11 on the first barrier layer 208, if corrosion time is excessively long, the isolation structure and the first electrical isolation structure are corroded. This may cause a short circuit and reduces a yield of the MEMS resonator. In this application, as shown in FIG. 21, the first electrical isolation structure isolates the first conducting structure from the first barrier layer 2082 and/or the second barrier layer 209, and the first barrier layer 208 and the dielectric isolation layer 206 isolate the first electrical isolation structure from the cavity. Therefore, when the sacrificial layer in the cavity is corroded, the first barrier layer 208 and the dielectric isolation layer 206 are used as transverse barrier layers. The transverse barrier layers can prevent the hydrofluoric acid vapor from corroding the first electrical isolation structure, thereby reducing a probability of a short circuit and improving a yield of the MEMS resonator. In addition, when a material of the second barrier layer 209 formed at a high temperature is polycrystalline silicon or amorphous silicon, residual gas in the cavity may be removed, thereby increasing a Q value of the MEMS resonator.

It should be understood that, that the dielectric isolation layer 206 may prevent the hydrofluoric acid vapor from corroding the first electrical isolation structure may be understood as that corrosion resistance of the dielectric isolation layer 206 is higher than corrosion resistance of the sacrificial layer 207 in the area 10.

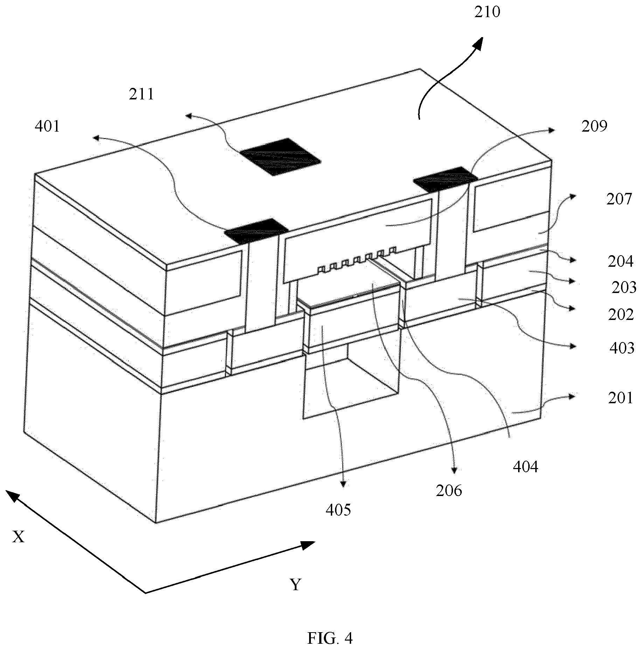

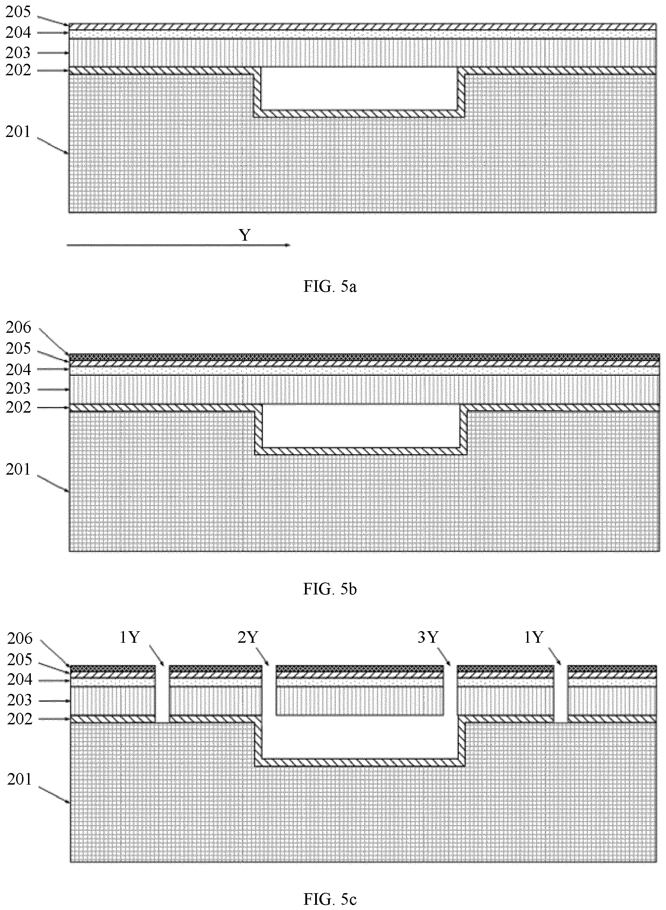

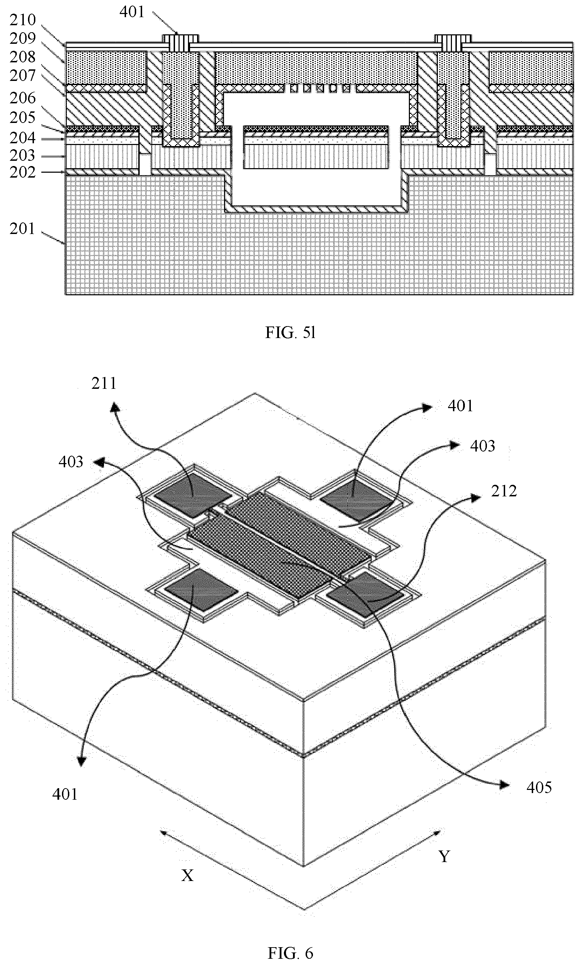

In addition to the foregoing upper electrode layer 205 and lower electrode layer, the MEMS resonator may further include a functional electrode. FIG. 4 is a schematic diagram of a three-dimensional structure of a MEMS resonator according to this application. FIG. 4 is a sectional view obtained by cutting FIG. 21 along a dashed line. For a direction of the X-axis in FIG. 4, refer to the direction of the X-axis in FIG. 21. FIG. 5a to FIG. 51 are schematic diagrams of another structure of a MEMS resonator in different processing stages according to this application. FIG. 2a to FIG. 21 are referred to as Y sectional views, and FIG. 5a to FIG. 51 are referred to as X sectional views. In addition, components in FIG. 4 and FIG. 5a to FIG. 51 use numbers as the same those in FIG. 2a to FIG. 21. Therefore, for descriptions in FIG. 4 and FIG. 5a to FIG. 51, correspondingly refer to related descriptions in FIG. 2a to FIG. 21. The following describes a processing procedure of a functional electrode with reference to FIG. 4, FIG. 5a to FIG. 51, and FIG. 1.

Step 101: Provide an SOI wafer including a substrate and a device silicon layer.

As shown in FIG. 5a, an SOI wafer includes a substrate 201, a silicon oxide layer 202, and a device silicon layer 203. A piezoelectric layer 204 and an upper electrode layer 205 are included on the device silicon layer 203. As shown in FIG. 5b, a dielectric isolation layer 206 is deposited on the upper electrode layer 205 through atomic layer deposition. For other descriptions, refer to the descriptions of the foregoing step 101. Similarly, in subsequent descriptions, for description of a step, refer to the description of the foregoing corresponding step. For example, for description of step 102, refer to the description of the foregoing step 102, and for description of step 103, refer to the description of the foregoing step 103.

Step 102: Etch the device silicon layer to form a harmonic oscillator and a support beam.

As shown in FIG. 4, two functional electrodes 403 are formed by etching the device silicon layer 203. The two functional electrodes 403 are located on two sides of the harmonic oscillator 405. The functional electrode 403 and the harmonic oscillator 405 form a capacitor. A capacitor gap 404 exists between the functional electrode 403 and the harmonic oscillator 405. Openings exist in the functional electrode 403 and another part of the conducting layer 203, and are configured to implement electrical isolation.

As shown in FIG. 5c, the dielectric isolation layer 206 is etched. In addition to an opening 1, an opening 2, and an opening 3 formed in the Y sectional view, an opening 1Y, an opening 2Y, and an opening 3Y are formed in the X sectional view. The opening 2Y and the opening 3Y are configured to form the capacitor gap 404. Apart between the opening 2Y and the opening 3Y is configured to form the harmonic oscillator 405. The device silicon layer 203 between the opening 1Y and the opening 2Y, and between the opening 1Y and the opening 3Y is configured to form the functional electrode 403. The opening 1Y is configured to isolate connection between the functional electrode 403 and another part of the device silicon layer 203.

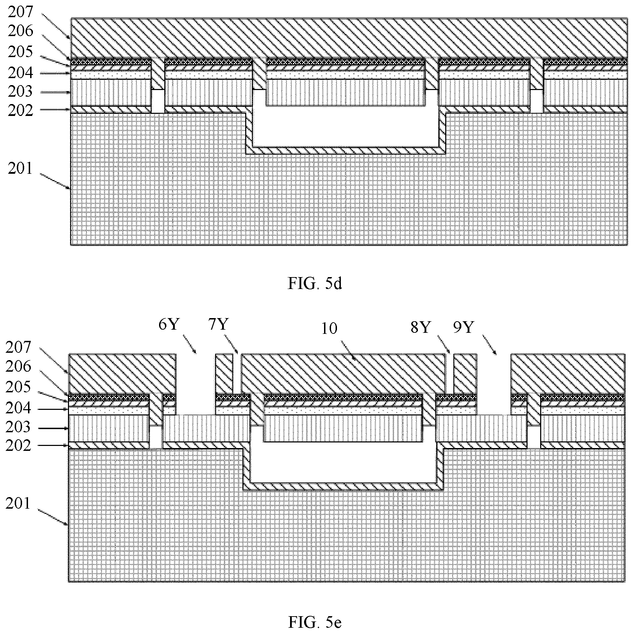

Step 103: Deposit a sacrificial layer on the device silicon layer. As shown in FIG. 5d, a sacrificial layer 207 is deposited on the device silicon layer 203.

Step 104: Etch the sacrificial layer, and epitaxially grow or deposit a first barrier layer on the sacrificial layer, so that the harmonic oscillator is located in a cavity formed by the first barrier layer and the substrate.

As shown in FIG. 5e, the sacrificial layer 207 is etched. In addition to an opening 6, an opening 7, an opening 8, and an opening 9 formed in the Y sectional view, an opening 6Y, an opening 7Y, an opening 8Y, and an opening 9Y are formed in the X sectional view. The opening 6Y and the opening 9Y are connected to the device silicon layer 203, to prepare for electrical connection to the functional electrode 403. The opening 7Y and the opening 8Y are connected to the dielectric isolation layer 206, and are used for subsequent generation of a first barrier layer or a second barrier layer. A distance between the opening 7Y and the opening 8Y is a width, in a Y-axis direction, of a cavity in which a subsequent harmonic oscillator is located. An area in which the sacrificial layer 207 between the opening 7Y and the opening 8Y is located is referred to as an area 10. The sacrificial layer 207 between the opening 6Y and the opening 7Y, and between the opening 8Y and the opening 9Y is referred to as a second electrical isolation structure.

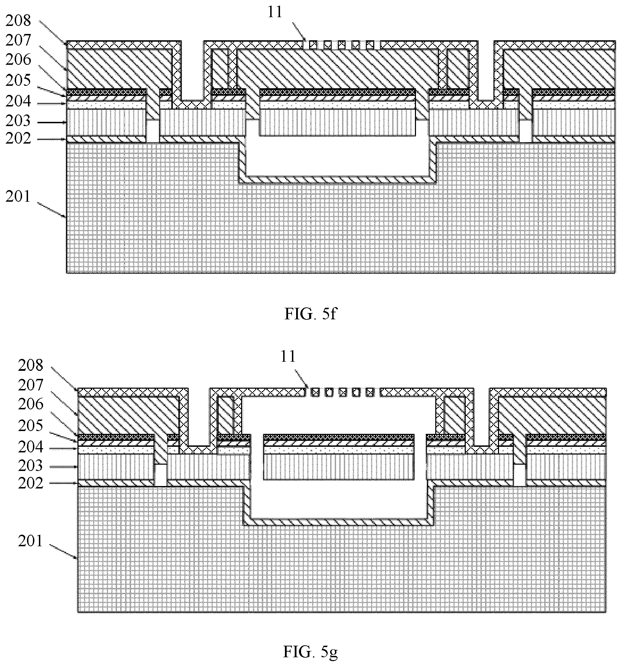

As shown in FIG. 5f, a first barrier layer 208 is formed on an etched sacrificial layer 207.

Step 105: Etch breather holes on the first barrier layer. As shown in FIG. 5f, breather holes 11 are etched on the first barrier layer 208.

Step 106: Inject hydrofluoric acid vapor through the breather holes to corrode the sacrificial layer, so that the harmonic oscillator is suspended, through the support beam, in the cavity.

As shown in FIG. 5g, because the breather holes 11 are connected to the sacrificial layer 207 in the area 10, after the hydrofluoric acid vapor is injected through the breather holes 11, the hydrofluoric acid vapor corrodes the sacrificial layer 207 in the area 10.

Step 107: Epitaxially grow a second barrier layer on the first barrier layer to seal the breather holes.

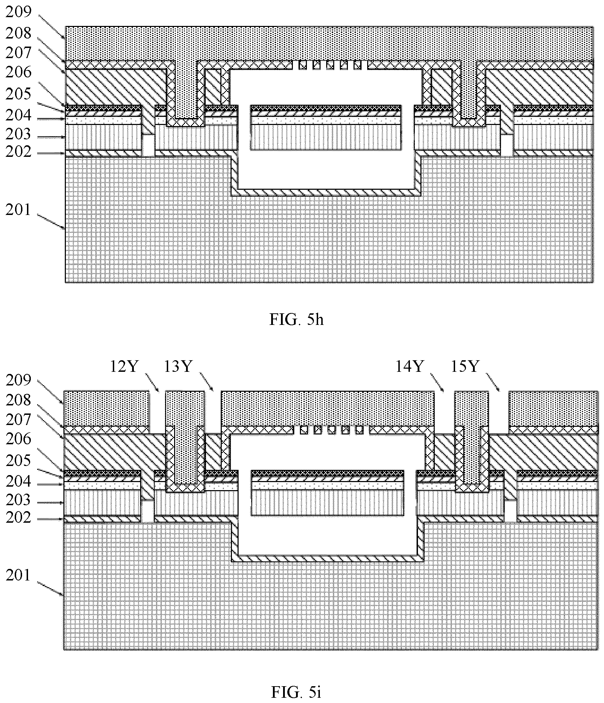

As shown in FIG. 5h, a second barrier layer 209 is epitaxially grown in a high-temperature vacuum environment to seal the breather holes 11. As shown in FIG. 5i, after the second barrier layer 209 is epitaxially grown, an electrical isolation groove is etched on the second barrier layer 209. In addition to an opening 12, an opening 13, an opening 14, and an opening 15 formed in the Y sectional view, an opening 12Y, an opening 13Y, an opening 14Y, and an opening 15Y are formed in the X sectional view. The opening 13Y and the opening 14Y are connected to the second electrical isolation structure. The second barrier layer 209 between the opening 12Y and the opening 13Y, and between the opening 14Y and the opening 15Y is referred to as a second conducting structure. The opening 12Y and the opening 15Y are configured to isolate connection between the second conducting structure and an edge part of the second barrier layer 209, to implement electrical isolation.

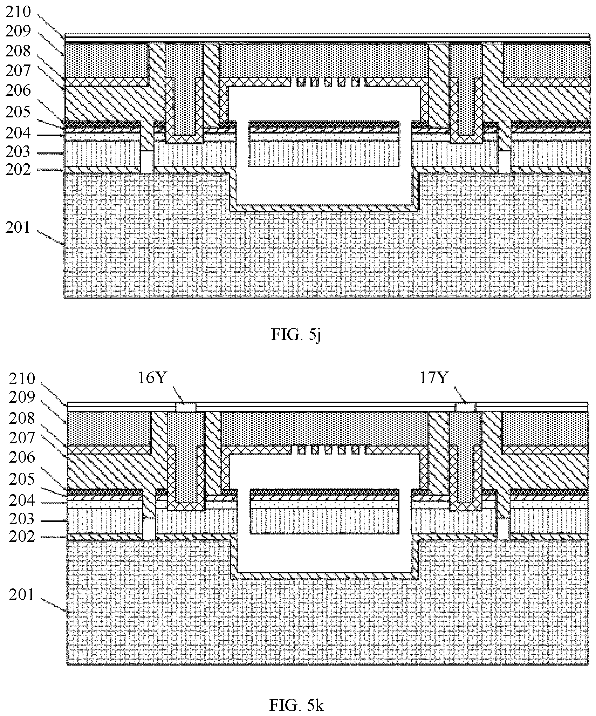

As shown in FIG. 5j, after the electrical isolation groove is etched, a protective layer 210 is deposited on the second barrier layer 209 by using an LPCVD method. As shown in FIG. 5k, after the protective layer 210 is deposited, an electrical through-hole is etched on the protective layer 210. In addition to an opening 16 and an opening 17 in the Y sectional view, the electrical through-hole further includes an opening 16Y and an opening 16Y in the X sectional view. As shown in FIG. 51, an electrical pad is formed by depositing metal on the electrical through-hole. The electrical pad includes functional electrode pads 401 formed on the opening 16Y and on the opening 17Y The functional electrode pad 401 is connected to the functional electrode 403 through the second conducting structure. A direct current bias voltage may be applied to the functional electrode 403 through the functional electrode pad 401. In this case, due to an electrostatic effect, the harmonic oscillator 405 generates an offset in a direction (Y direction) of the capacitor. In addition, when the harmonic oscillator 405 generates an offset, a resonance frequency of the harmonic oscillator 405 changes. Therefore, in this application, the functional electrode 403 is disposed, to implement frequency adjustment of the harmonic oscillator

It should be understood that FIG. 4 includes two symmetric functional electrodes 403. In actual application, only one functional electrode 403 may be included.

When an alternating current voltage is applied to the functional electrode 403, the alternating current voltage is used as vibration excitation of the harmonic oscillator 405, which is briefly referred to as electrostatic excitation. In this case, a voltage applied to the upper electrode layer of the harmonic oscillator 405 may be used to perform detection on a vibration frequency of the harmonic oscillator 405, which is briefly referred to as piezoelectric detection. Through piezoelectric detection, it can be determined whether the vibration frequency of the harmonic oscillator meets an expected frequency. On the contrary, when a voltage applied to the upper electrode layer is used as vibration excitation of the harmonic oscillator 405, the voltage is briefly referred to as piezoelectric excitation. In this case, a direct current bias voltage applied to the functional electrode 403 may be used to perform detection on a vibration frequency of the harmonic oscillator 405, which briefly is referred to as electrostatic detection. In this application, the functional electrode 403 is disposed, to flexibly implement conversion between electrostatic excitation (piezoelectric detection) and piezoelectric excitation (electrostatic detection).

The following additionally describes connection manners of the functional electrode in this application. FIG. 6 is a schematic diagram of electrical connections of a MEMS resonator according to this application. As shown in FIG. 6, the MEMS resonator includes a lower electrode pad 211, an upper electrode pad 212, a functional electrode pad 401, a functional electrode 403, and a harmonic oscillator 405. A capacitor is formed between the harmonic oscillator 405 and the functional electrode 403. The functional electrode 403 is connected to the functional electrode pad 401. The lower electrode pad 211 is connected to a lower electrode layer of the harmonic oscillator 405, and the upper electrode pad 212 is connected to an upper electrode layer of the harmonic oscillator 405. In FIG. 6, a direction of a support beam is an X direction. A direction of an electrostatic force generated by the functional electrode 403 on the harmonic oscillator 405 is a Y direction. A direction of a capacitor formed between the functional electrode 403 and the harmonic oscillator is a Y direction. Two functional electrodes 403 include a first functional electrode and a second functional electrode. The first functional electrode and the harmonic oscillator 405 form a first capacitor, and the second functional electrode and the harmonic oscillator 405 form a second capacitor. The first capacitor and the second capacitor are distributed symmetric about the harmonic oscillator 405.

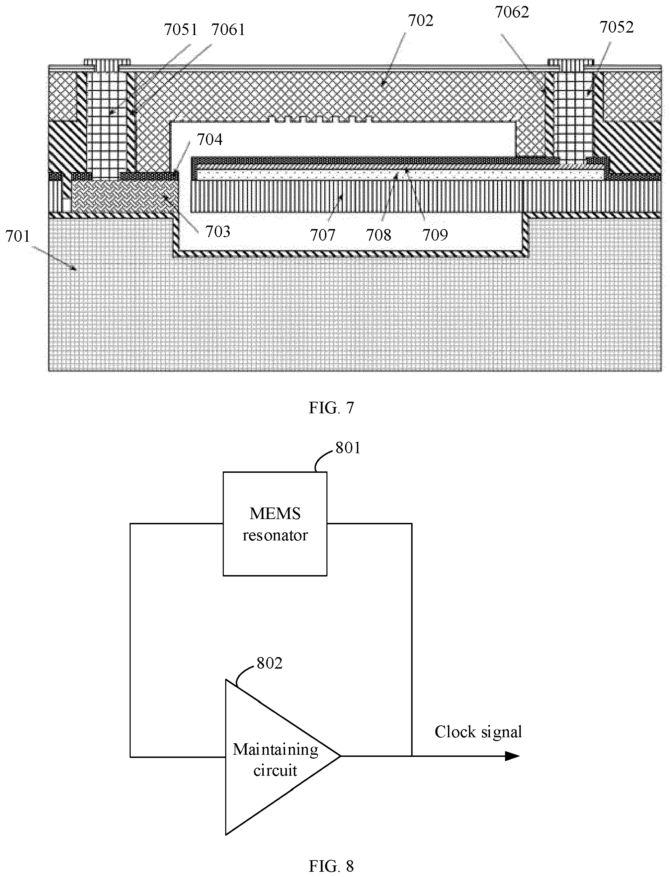

The MEMS resonator processing method in this application is described above. The following describes the MEMS resonator in this application. FIG. 7 is a schematic diagram of a structure of a MEMS resonator according to this application. As shown in FIG. 7, the MEMS resonator includes a substrate 701, a harmonic oscillator, and a barrier layer 702. The MEMS resonator includes a substrate 701, a barrier layer 702, a conducting layer 703, a dielectric isolation layer 704, a harmonic oscillator, a first electrical isolation structure 7061, and a first conducting structure 7051. The substrate 701 and the barrier layer 702 are combined to form a cavity. A junction between the substrate 701 and the barrier layer 702 includes the conducting layer 703. The dielectric isolation layer 704 is included between the conducting layer 703 and the barrier layer 702, and the dielectric isolation layer 704 is configured to isolate electrical connection between the conducting layer 703 and the barrier layer 702. The harmonic oscillator is suspended in the cavity. The harmonic oscillator includes an upper electrode layer 709, a piezoelectric layer 708, and a lower electrode layer 707. The lower electrode layer 707 is connected to the conducting layer 703 (not shown in the figure). The conducting layer 703 is connected to the first conducting structure 7051 that is outside the barrier layer 702. The first conducting structure 7051 may provide excitation for the harmonic oscillator, so that the harmonic oscillator vibrates in the cavity. The first electrical isolation structure 7061 is included between the first conducting structure 7051 and the barrier layer 702. The first electrical isolation structure 7061 is configured to isolate electrical connection between the first conducting structure 7051 and the barrier layer 702. The barrier layer 702 and the dielectric isolation layer 704 are configured to isolate the first electrical isolation structure 7051 from the cavity.

It should be understood that, in FIG. 7, the junction between the barrier layer 702 and the substrate 701 includes two parts: a left part and a right part. The left part includes the conducting layer 703. When the right part is also a conducting layer, the right conducting layer includes an upper electrode layer, a piezoelectric layer, and a device silicon layer. A dielectric isolation layer is included between the right conducting layer and the barrier layer 702, and the dielectric isolation layer is configured to isolate electrical connection between the right conducting layer and the barrier layer 702. The harmonic oscillator is suspended in the cavity. The harmonic oscillator includes an upper electrode layer 709, a piezoelectric layer 708, and a lower electrode layer 707. The upper electrode layer 709 is connected to the right conducting layer. The right conducting layer is connected to a first conducting structure 7052 that is outside the barrier layer 702. A first electrical isolation structure 7062 is included between the first conducting structure 7052 and the barrier layer 702. The first electrical isolation structure 7062 is configured to isolate electrical connection between the first conducting structure 7052 and the barrier layer 702. The barrier layer 702 and the dielectric isolation layer are configured to isolate the first electrical isolation structure 7052 from the cavity.

For descriptions of the MEMS resonator in this application, refer to related descriptions of FIG. 1, FIG. 2a to FIG. 21, FIG. 3, FIG. 4, FIG. 5a to FIG. 51, or FIG. 6. For example, for the substrate 701, refer to the substrate 201 in FIG. 2a to FIG. 21. For the barrier layer 702, refer to the first barrier layer 208 and the second barrier layer 209 between an opening 11 and the opening 12 in FIG. 2i. For the first conducting structure 7051, refer to the first barrier layer 208 and the second barrier layer 209 between the opening 12 and the opening 13 in FIG. 2i. For the dielectric isolation layer 704, refer to the dielectric isolation layer 206 in FIG. 2a to FIG. 21. For the first electrical isolation structure 7061, refer to the sacrificial layer 207 filled in the opening 11 in FIG. 2i. For the upper electrode layer 709, refer to the upper electrode layer 205 in FIG. 5a to FIG. 51. For the piezoelectric layer 708, refer to the piezoelectric layer 204 in FIG. 5a to FIG. 51. For the lower electrode layer 707, refer to the device silicon layer 203 in the cavity in FIG. 5a to FIG. 51. For example, the conducting layer may be the device silicon layer 203 at the junction between the barrier layer 702 and the substrate 701 in FIG. 2i to FIG. 21. For example, as shown in FIG. 4, the MEMS resonator further includes a functional electrode.

It should be understood that, FIG. 1, FIG. 2a to FIG. 21, FIG. 4, or FIG. 5a to FIG. 51 provide a plurality of MEMS resonator processing methods. The plurality of processing methods can be used to obtain the MEMS resonator provided in this application. Therefore, in actual application, there are more processing methods that can be used to obtain the MEMS resonator provided in this application. The processing methods provided in this application are merely particular examples among many processing methods. Therefore, the foregoing MEMS resonator processing method may be used as a reference for the MEMS resonator provided in this application, but shall not be used as a limiting condition.

The MEMS resonator provided in this application is described above. The following describes a clock device in this application. FIG. 8 is a schematic diagram of a structure of a clock device according to this application. As shown in FIG. 8, the clock device includes a MEMS resonator 801 and a maintaining circuit 802. The maintaining circuit 802 provides closed-loop oscillation excitation for the MEMS resonator 801. The MEMS resonator 801 generates a clock signal through oscillation excitation. For the MEMS resonator 801, refer to the foregoing MEMS resonator provided in this application.

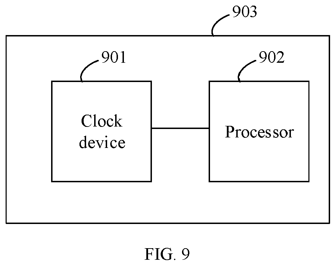

The clock device provided in this application is described above. The following describes a terminal in this application. FIG. 9 is a schematic diagram of a structure of a terminal according to this application. The terminal may be a mobile phone, a computer, a base station, or the like. As shown in FIG. 9, the terminal 903 includes a clock device 901 and a processor 902. The clock device 901 is configured to provide a clock signal for the processor 902. The processor 902 performs operation processing based on the clock signal.

The processor 901 may be a central processing unit (central processing unit, CPU), a network processor (network processor, NP), or a combination of a CPU and an NP. The processor 901 may further include a hardware chip or another general purpose processor. The hardware chip may be an application-specific integrated circuit (application specific integrated circuit, ASIC), a programmable logic device (programmable logic device, PLD), or a combination thereof.

The clock device 901 may be a MEMS clock device. Specifically, for the clock device 901, refer to the foregoing clock device provided in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A micro electro mechanical system MEMS resonator, comprising:
a substrate, a barrier layer, a conducting layer, a dielectric isolation layer, a harmonic oscillator, a first electrical isolation structure, and a first conducting structure, wherein
the substrate and the barrier layer are combined to form a cavity, a junction between the substrate and the barrier layer comprises the conducting layer, the dielectric isolation layer is comprised between the conducting layer and the barrier layer, and the dielectric isolation layer is configured to isolate electrical connection between the conducting layer and the barrier layer;
the harmonic oscillator is connected to the conducting layer and is suspended in the cavity;
the conducting layer is connected to the first conducting structure that is outside the barrier layer, and the first electrical isolation structure is comprised between the first conducting structure and the barrier layer; and
the barrier layer and the dielectric isolation layer are configured to isolate the first electrical isolation structure from the cavity.

2. The MEMS resonator according to claim 1, wherein the barrier layer comprises a first barrier layer and a second barrier layer; and
breather holes are disposed on the first barrier layer, and the second barrier layer is configured to seal the breather holes to seal the harmonic oscillator in the cavity.

3. The MEMS resonator according to claim 2, wherein a material of the second barrier layer is polycrystalline silicon or amorphous silicon.

4. The MEMS resonator according to claim 2 or 3, wherein a material of the first barrier layer is different from a material of the first electrical isolation structure.

5. The MEMS resonator according to any one of claims 2 to 4, wherein the material of the second barrier layer is the same as the material of the first barrier layer

6. The MEMS resonator according to any one of claims 1 to 5, wherein
the harmonic oscillator comprises an upper electrode layer, a piezoelectric layer, and a lower electrode layer, and the piezoelectric layer is located between the upper electrode layer and the lower electrode layer; and
the dielectric isolation layer covers the upper electrode layer and the piezoelectric layer

7. The MEMS resonator according to any one of claims 1 to 6, wherein a material of the dielectric isolation layer is aluminum oxide Al₂O₃.

8. The MEMS resonator according to any one of claims 1 to 7, wherein a thickness of the dielectric isolation layer is 0.01 µm to 2 µm.

9. The MEMS resonator according to any one of claims 1 to 8, wherein the MEMS resonator further comprises a functional electrode, and the functional electrode and the harmonic oscillator form a capacitor; and
when a direct current bias voltage is applied to the functional electrode, the harmonic oscillator generates an offset in a fixed direction.

10. The MEMS resonator according to claim 9, wherein the functional electrode comprises a first functional electrode and a second functional electrode;
the first functional electrode and the harmonic oscillator form a first capacitor;
the second functional electrode and the harmonic oscillator form a second capacitor; and
the first capacitor and the second capacitor are distributed symmetric about the harmonic oscillator.

11. The MEMS resonator according to claim 9 or 10, wherein the functional electrode is connected to a second conducting structure that is outside the barrier layer, and a second electrical isolation structure is comprised between the second conducting structure and the barrier layer; and
the barrier layer and the dielectric isolation layer are configured to isolate the second electrical isolation structure from the cavity.

12. The MEMS resonator according to any one of claims 9 to 11, wherein when an alternating current voltage is applied to the functional electrode, the harmonic oscillator vibrates based on the alternating current voltage.

13. The MEMS resonator according to any one of claims 1 to 12, wherein the MEMS resonator further comprises a support beam; and
the harmonic oscillator is connected to the conducting layer through the support beam and is suspended in the cavity.

14. The MEMS resonator according to any one of claims 1 to 13, wherein the MEMS resonator further comprises a protective layer above the barrier layer.

15. The MEMS resonator according to claim 14, wherein an electrical through-hole is disposed on the protective layer, and an electrode pad is deposited on the electrical through-hole; and
the electrode pad is connected to the first conducting structure.

16. The MEMS resonator according to any one of claims 1 to 15, wherein a surface of the substrate comprises a silicon oxide layer.

17. The MEMS resonator according to any one of claims 1 to 16, wherein a processing temperature of the second barrier layer is greater than 500 degrees Celsius.

18. A micro electro mechanical system MEMS resonator processing method, comprising:
providing a silicon-on-insulator SOI wafer comprising a substrate and a conducting layer;
etching the conducting layer to form a harmonic oscillator and a support beam, wherein the harmonic oscillator is connected to the conducting layer through the support beam;
depositing a dielectric isolation layer and a sacrificial layer on the conducting layer;
etching the sacrificial layer, and epitaxially growing or depositing a first barrier layer on the sacrificial layer, so that the harmonic oscillator is located in an area formed by the first barrier layer and the substrate;
etching breather holes on the first barrier layer;
injecting hydrofluoric acid vapor through the breather holes to corrode the sacrificial layer in the area, so that the harmonic oscillator is suspended, through the support beam, in a cavity formed by the area; and
epitaxially growing a second barrier layer on the first barrier layer to seal the harmonic oscillator in the cavity, wherein
the conducting layer is connected to a first conducting structure that is outside the barrier layer, a first electrical isolation structure is comprised between the first conducting structure and the barrier layer, and the barrier layer and the dielectric isolation layer are configured to isolate the first electrical isolation structure from the cavity.

19. A clock device, comprising: a micro electro mechanical system MEMS resonator and a maintaining circuit, wherein
the maintaining circuit is configured to provide closed-loop oscillation excitation for the MEMS resonator;
the MEMS resonator generates a clock signal through oscillation excitation; and
the MEMS resonator is the MEMS resonator according to any one of claims 1 to 17.
